# EUROPÄISCHE PATENTSCHRIFT

(11) **EP 0 951 809 B1**
(45) Veröffentlichungstag und Bekanntmachung des Hinweises auf die Patenterteilung: **27.11.2002**
(21) Anmeldenummer: 98904009.2
(22) Anmeldetag: 07.01.1998
(51) Int. Cl.: H05K 13/02, H05K 13/04

(54) **ZUFÜHREINRICHTUNG ZUM ZUFÜHREN VON ELEKTRISCHEN BAUTEILEN AN EINEN BESTÜCKAUTOMATEN**
DEVICE FOR FEEDING ELECTRIC COMPONENTS TO AN ASSEMBLY AUTOMATON
DISPOSITIF D'AMENAGE DE COMPOSANTS ELECTRIQUES A UN AUTOMATE DE MONTAGE

(30) Priorität: 13.01.1997 DE 19700841
(43) Veröffentlichungstag der Anmeldung: 27.10.1999
(73) Patentinhaber: SIEMENS AKTIENGESELLSCHAFT, 80333 München (DE)
(72) Erfinder: BARNOWSKI, Frank, D-81475 München (DE); MEHDIANPOUR, Mohammad, D-81829 München (DE)
(86) Internationale Anmeldenummer: DE9800032
(87) Internationale Veröffentlichungsnummer: WO98031206

(56) Entgegenhaltungen:
- DE-A- 3 805 781
- DE-A- 4 137 191
- US-A- 5 515 600

## Beschreibung

Die Erfindung bezieht sich auf eine Zuführeinrichtung zum Zuführen von elektrischen Bauteilen an einen Bestückautomaten zum Bestücken von elektrischen Leiterplatten.

Eine derartige Zuführeinrichtung ist z.B. durch die EP 0 599 319 B1 bekannt geworden. Danach weist die Zuführeinrichtung ein Magazin für Spulen mit Bauteilegurten auf, wobei die Spulen in ihrer Achsrichtung stapelartig aneinanderreihbar sind. Die Spulen sind einzeln an blechartigen Flachteilen gehalten, die an der Zuführeinrichtung um eine Schwenkachse ausschwenkbar gelagert sind. Die Flachteile sind an ihrer Lagerstelle mit einer schlitzartigen Ausnehmung versehen, in die die Schwenkachse eingreift. Die Zuführeinrichtung weist in der Nähe der Schwenkachse mit seitlichen Führungsschlitzen versehene kammartige Führungsbleche für die Flachteile auf. Ein weiteres kammartiges Führungsteil ist am anderen Ende der Flachteile angeordnet, so daß diese an zwei Stellen seitlich gehalten werden können.

Der Erfindung liegt die Aufgabe zugrunde, die Zuführeinrichtung baulich zu vereinfachen und die Bedienung zu vereinfachen. Diese Aufgabe wird durch die Erfindung gemäß Anspruch 1 gelöst.

Die vorzugsweise kreisrunden Führungsscheiben können mit den Abstandselementen in abwechselnder Reihenfolge auf die Schwenkachse aufgesteckt und zwischen seitlichen Stützen der Schwenkachse gesichert sein. Die Abstandselemente können z.B. als separate Distanzscheiben ausgebildet oder einstückig mit den Führungsscheiben verbunden sein. Zwischen den Abstandsscheiben ergibt sich eine Führungslänge für die Flachteile von annähernd dem Durchmesser der Führungsscheiben. Diese Führungslänge reicht aus, um auf zusätzliche Führungen, z.B. am anderen Ende der Flachteile zu verzichten.

Nach dem Einstecken sind die Flachteile in jeder Schwenklage hinreichend geführt. Zum Auswechseln von Spulen können einzelne Flachteile mit den Spulen aus ihrer Abzugslage weitwinkelig herausgeschwenkt werden und danach ohne einen Einfädelvorgang zurückgeschwenkt werden.

Durch eine vorteilhafte Weiterbildung der Erfindung nach Anspruch 2 können die freien Enden der Flachteile außerhalb der Gurtabzugsebene verbleiben und sind zum Zwecke des Herausschwenkens gut zugänglich.

Im folgenden wird die Erfindung anhand eines in der Zeichnung dargestellten Ausführungsbeispieles näher erläutert.
- Figur 1: zeigt eine partielle Seitenansicht einer Zuführeinrichtung für elektronische Bauteile,
- Figur 2: eine andere Seitenansicht der Zuführeinrichtung nach Figur 1,
- Figur 3: einen vergrößerten Teilschnitt durch die Zuführeinrichtung nach Figur 2.

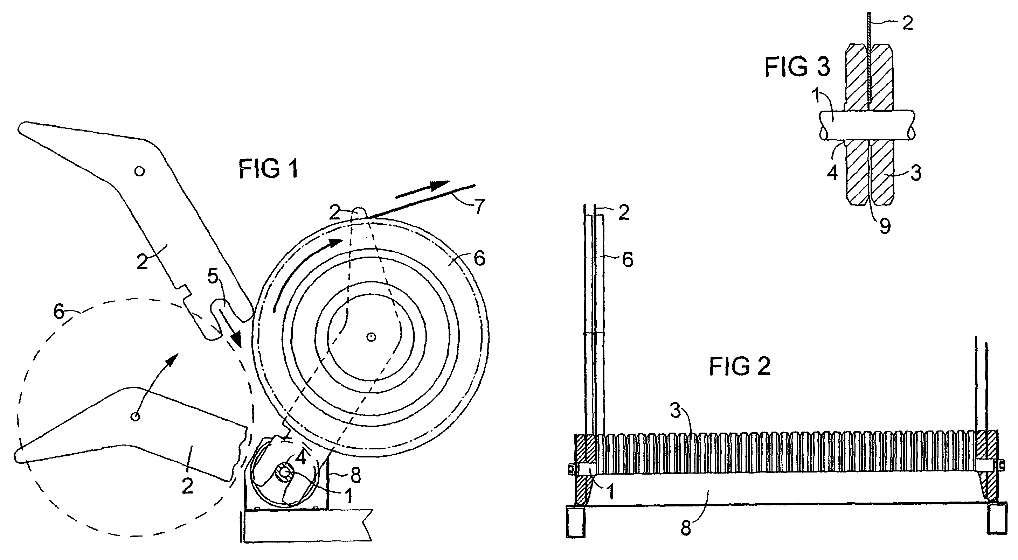

Nach den Figuren 1, 2 und 3 ist eine Zuführeinrichtung mit einer Schwenkachse 1 versehen, auf der als blechartige Flachteile 2 ausgebildete Spulenhalter schwenkbar gelagert sind. Über die Schwenkachse sind kreisrunde Führungsscheiben 3 geschoben, zwischen denen ringförmige Abstandselemente 4 von der Dicke der Flachteile 2 angeordnet sind. Die Abstandselemente 4 ergeben zwischen den Führungsscheiben 3 entsprechend weite Führungsschlitze 9, in die die Flachteile 2 spielarm einsetzbar sind. Die schwertartig ausgebildeten Flachteile 2 sind an ihrem die Schwenkachse 1 übergreifenden gabelartigen Ende mit einer Ausnehmung 5 versehen, deren Weite größer als der Durchmesser der Abstandselemente ist. Mit diesem Ende kann das Flachteil zwischen die Führungsscheiben über die Schwenkachse 1 mit dem Abstandselement 4 eingesteckt werden und wird so über eine hinreichende Einspannlänge seitlich geführt.

In Figur 1 sind die Flachteile in drei verschiedenen Stellungen dargestellt, wobei das rechte Flachteil in der Funktionsstellung mit einer daran befestigten Spule 6 dargestellt ist, in der ein Bauteilegurt 7 in der angedeuteten Pfeilrichtung zu einem Zuführmodul abgezogen wird. Die linke Schwenkstellüng zeigt die Auswechsellage der einzeln ausschwenkbaren Flachteile 2. In dieser Stellung sind die Spulen 6 soweit ausgeschwenkt, daß sie nicht mehr zwischen die anderen Spulen 6 ragen. Das mittlere Flachteil 2 ist in seiner Einsteckstellung gezeigt, in der es von außen gemäß der angedeuteten Pfeilrichtung mit dem gabelartigen Ende zwischen die Führungsscheiben 3 eingesteckt werden kann.

Die Schwenkbewegungen sind durch ein U-förmig gebogenes Anschlagblech 8 begrenzt, daß sich entlang der aneinandergereihten Führungsscheiben 3 erstreckt und mit unterschiedlich hohen Seitenschenkeln versehen ist, an denen die Flachteile 2 anschlagen.

## Patentansprüche

1. Zuführeinrichtung zum Zuführen von elektrischen Bauteilen an einen Bestückautomaten zum Bestücken von elektrischen Leiterplatten,
wobei die Zuführeinrichtung mit einem Magazin für in ihrer Achsrichtung aneinanderreihbare Spulen (6) mit Bauteilegurten (7) versehen ist,
wobei die Spulen (6) einzeln an blechartigen Flachteilen (2) gehalten sind, die an der Zuführeinrichtung um eine Schwenkachse (1) parallel zur Achsrichtung der Zuführeinrichtung ausschwenkbar gelagert sind,
wobei die Flachteile (2) an ihrer Lagerstelle gabelartig ausgebildet sind und mit einer schlitzartigen Ausnehmung (5) versehen sind, in die die Schwenkachse (1) eingreift und
wobei die Zuführeinrichtung in der Nähe der Schwenkachse (1) mit seitlichen Führungsschlitzen (9) versehen ist, in die die Flachteile (2) in ihrer Funktionsstellung hineinragen,
**dadurch gekennzeichnet,**
**daß** die Führungsschlitze (9) zwischen Führungsscheiben (3) ausgebildet sind, die mit einer zentralen Bohrung auf die Schwenkachse (1) aufgeschoben und aneinandergereiht sind,
**daß** zwischen den Führungsscheiben (3) ringartige Abstandselemente (4) angeordnet sind, deren Dicke mindestens gleich der Dicke der Flachteile (2) ist und
**daß** die Weite der Ausnehmung (5) größer ist als der Durchmesser der Abstandselemente (4).

2. Zuführeinrichtung nach Anspruch 1,
**dadurch gekennzeichnet,**
**daß** die Flachteile (2) die Spulen (6) zumindest geringfügig überragen und von der Mittelachse der Spule aus entgegengesetzt der Abzugsrichtung der Gurte (7) nach außen abgeknickt verlaufend ausgebildet sind.

## Claims

1. Feed device for feeding electric components to an automatic placement machine for populating electrical printed circuit boards,
the feed device being provided with a magazine for coils (6) which can be lined up in a row in their axial direction and comprise component belts (7),
the coils (6) being held individually on sheet-like flat parts (2), which are mounted on the feed device such that they can be pivoted out about a pivot axis (1), parallel to the axial direction of the feed device,
the flat parts (2) being of fork-like design at their bearing points and being provided with a slot-like cutout (5), in which the pivot axis (1) engages, and
the feed device being provided, in the vicinity of the pivot axis (1), with lateral guide slots (9) into which the flat parts (2) project when in their functional position,
**characterized**
**in that** the guide slots (9) are formed between guide discs (3), which are pushed with a central bore onto the pivot axis (1) and are lined up in a row,
**in that** ring-like spacer elements (4) are arranged between the guide discs (3), their thickness being at least equal to the thickness of the flat parts (2), and
**in that** the width of the cutout (5) is greater than the diameter of the spacer elements (4).

2. Feed device according to Claim 1, **characterized in that** the flat parts (2) project at least slightly beyond the coils (6) and, from the mid-axis of the coil outwards, are designed to extend with an outward bend opposed to the pull-off direction of the belts (7).

## Revendications

1. Dispositif d'amenée destiné à amener des composants électriques sur un robot d'assemblage en vue d'équiper des cartes à circuits imprimés électriques,
le dispositif d'amenée étant muni d'un magasin pour des bobines (6) à rubans (7) de composants qui peuvent être empilées dans le sens de leur axe,
les bobines étant maintenues individuellement par des pièces plates (2) en forme de tôles, qui sont montées sur le dispositif d'amenée autour d'un axe de basculement (1) de telle sorte qu'elles peuvent basculer parallèlement au sens axial du dispositif d'amenée,
les pièces plates (2) étant conçues en forme de fourche au niveau de leur point de fixation et étant munies d'un évidement (5) en forme de fente dans lequel s'introduit l'axe de basculement (1) et
le dispositif d'amenée étant muni à proximité de l'axe de basculement (1) de fentes de guidage (9) latérales dans lesquelles les pièces plates (2) s'engagent dans leur position de fonctionnement
**caractérisé par le fait**
**que** les fentes de guidage (9) sont formées entre les disques de guidage (3), lesquels, ayant un alésage central, sont enfichés et empilés sur l'axe de basculement (1),
**que**, entre les disques de guidage (3), sont disposés des éléments d'écartement (4) circulaires dont l'épaisseur est au moins égale à l'épaisseur des pièces plates (2) et
**que** la largeur de l'évidement (5), est supérieur au diamètre des éléments d'écartement (4).

2. Dispositif d'amenée selon la revendication 1
**caractérisé par le fait**
**que** les pièces plates (2) dépassent au moins un peu des bobines (6) et ont une forme courbe vers l'extérieur dans le sens contraire à la direction de tirage des rubans (7), vue de l'axe central de la bobine.
